(19) Europäisches Patentamt
European Patent Office
Office européen des brevets

(11) EP 2 505 613 A1

(12) **EUROPEAN PATENT APPLICATION**
published in accordance with Art. 153(4) EPC

(43) Date of publication:
**03.10.2012 Bulletin 2012/40**

(21) Application number: **10832991.3**

(22) Date of filing: **15.10.2010**

(51) Int Cl.:
***C08L 83/05*** *(2006.01)* ***C08G 77/58*** *(2006.01)*
***C08K 5/057*** *(2006.01)* ***H01L 51/50*** *(2006.01)*
***H05B 33/04*** *(2006.01)*

(86) International application number:
**PCT/JP2010/068114**

(87) International publication number:
**WO 2011/065144 (03.06.2011 Gazette 2011/22)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.11.2009 JP 2009270018**
**16.03.2010 JP 2010059149**

(71) Applicant: **JSR Corporation**
**Minato-ku**
**Tokyo 105-8640 (JP)**

(72) Inventors:
- **ARAI, Takayuki**
  **Tokyo 105-8640 (JP)**
- **TAKAHASHI, Masayuki**
  **Tokyo 105-8640 (JP)**
- **KONNO, Keiji**
  **Tokyo 105-8640 (JP)**
- **MATSUKI, Yasuo**
  **Tokyo 105-8640 (JP)**

(74) Representative: **TBK**
**Bavariaring 4-6**
**80336 München (DE)**

# (54) COMPOSITION, CURED PRODUCT, AND ELECTRONIC DEVICE

(57) A composition includes (A) a compound shown by the following general formula (1), and (B) a compound shown by the following general formula (2).

$(R^1)nM$ (1)

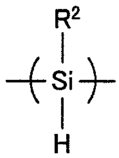

···(2)

EP 2 505 613 A1

## Description

### TECHNICAL FIELD

The present invention relates to a composition, a cured product formed using the composition, and an electronic device that includes the cured product.

### BACKGROUND ART

An electronic device (e.g., capacitor or organic EL device) that sustains damage from moisture (water) must be used in a sealed environment so as to exclude moisture. However, entrance of moisture cannot be completely prevented only by utilizing a sealing agent that is generally used for such a sealed electronic device. If an electronic device is not provided with a mechanism that removes moisture that gradually enters the electronic device, the performance of the electronic device deteriorates over time.

For example, an organic EL device (i.e., representative sealed electronic device) has a problem in that the emission properties (e.g., luminance or emission efficiency) gradually decrease due to entrance of moisture when the organic EL device is driven for a long time.

As a means for protecting such a sealed electronic device from moisture that has entered the electronic device, JP-A-2005-298598 and JP-T-2008-518399 disclose a technique that disposes a moisture absorber (e.g., organometallic compound or metal alkoxide) in the electronic device in advance so as to maintain the inside of the electronic device at low humidity.

### SUMMARY OF THE INVENTION

### TECHNICAL PROBLEM

However, an organometallic compound or a metal alkoxide used as the moisture absorber reacts with moisture (water) to form a hydrolyzate (e.g., alkane or alcohol).

If such a hydrolyzate diffuses inside the electronic device, the hydrolyzate may be absorbed by an organic material that forms a carrier transporting layer, an organic emitting layer, or the like included in the electronic device, or may cause volume expansion of the space present in the electronic device. As a result, pinholes or deformation of the electronic device may occur, and may promote entrance of moisture, which may result in a decrease in the lifetime of the electronic device.

Moreover, it is generally necessary to form a film by dissolving the moisture absorber in a solvent to prepare a coating liquid, applying the coating liquid by spin coating or the like, and then removing the solvent. However, the solvent may remain in the film when using such a method. In this case, the solvent may be absorbed by an organic material that forms a carrier transporting layer, an organic emitting layer, or the like included in the electronic device, or may cause volume expansion of the space present in the electronic device. As a result, pinholes or deformation of the electronic device may occur, and may promote entrance of moisture, which may result in a decrease in the lifetime of the electronic device. Therefore, development of a moisture absorber from which a solvent is removed as much as possible has been desired.

A moisture absorber may be thermally deformed under a usage environment (e.g., at a temperature of about 80°C for an organic EL lighting device or the like), or may become opaque via a reaction with water (moisture).

Since a moisture absorber is generally formed on the surface of a glass substrate or the like, the moisture absorber is required to exhibit an excellent film-forming capability and excellent adhesion to glass.

Several aspects of the invention may provide a moisture-absorbing composition that can form a cured product that exhibits excellent hygroscopicity, heat resistance (decreased thermal fluidity), transparency, film-forming capability, and adhesion to glass, a cured product that is formed using the composition, and an electronic device that includes the cured product.

### SOLUTION TO PROBLEM

The invention was conceived in order to solve at least some of the above problems, and may be implemented as follows.

[Application Example 1]

According to one aspect of the invention, there is provided a composition including (A) a compound shown by

a general formula (1), and (B) a compound shown by a general formula (2),

$(R^1)nM$ (1)

wherein $R^1$ independently represent a group selected from a substituted or unsubstituted alkyl group, a substituted or unsubstituted alkenyl group, a substituted or unsubstituted alkynyl group, a substituted or unsubstituted cyclic alkyl group, a substituted or unsubstituted aryl group, a substituted or unsubstituted carboxyl group, and a group shown by $R^3O$-, provided that at least one of $R^1$ represents a group that includes one or more unsaturated bonds, $R^3$ represents a group selected from a substituted or unsubstituted alkyl group, a substituted or unsubstituted alkenyl group, a substituted or unsubstituted alkynyl group, a substituted or unsubstituted cyclic alkyl group, and a substituted or unsubstituted aryl group, n is an integer from 2 to 4 that is equal to a valence of M, and M represents an atom having a valence of 2 to 4,

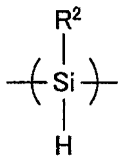 ···(2)

wherein $R^2$ represents an atom or a group selected from a hydrogen atom, a halogen atom, and an organic group.

[Application Example 2]

In the composition according to Application Example 1, the compound (A) may include a carbon-carbon unsaturated bond.

[Application Example 3]

In the composition according to Application Example 1 or 2, M in the general formula (1) may represent at least one atom selected from aluminum, boron, magnesium, calcium, titanium, zirconium, and zinc.

[Application Example 4]

In the composition according to any one of Application Examples 1 to 3, the compound (B) may be a polysiloxane that includes a repeating unit shown by a general formula (3),

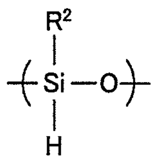 ···(3)

wherein $R^2$ represents an atom or a group selected from a hydrogen atom, a halogen atom, and an organic group.

[Application Example 5]

In the composition according to any one of Application Examples 1 to 4, the compound (A) may be a compound shown by a general formula (4),

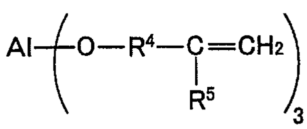 ···(4)

wherein $R^4$ independently represent a divalent organic group, and $R^5$ independently represent a hydrogen atom or a monovalent organic group.

[Application Example 6]

The composition according to any one of Application Examples 1 to 5 may further include (C) a catalyst that promotes a hydrosilylation reaction between the compound (A) and the compound (B).

[Application Example 7]

The composition according to any one of Application Examples 1 to 6 may further include at least one stabilizer selected from benzothiazole, tris(2,4-di-t-butylphenyl)phosphite, 1-ethynyl-1-cyclohexanol, diethyl maleate, N-methylpyrrolidone, 1,3-dimethyl-2-imidazolidone, and N-vinyl-epsilon-caprolactam.

[Application Example 8]

The composition according to any one of Application Examples 1 to 7 may be used for a moisture-absorbing application.

[Application Example 9]

According to another aspect of the invention, there is provided a cured product formed using the moisture-absorbing composition according to Application Example 8.

[Application Example 10]

According to a further aspect of the invention, there is provided an electronic device including the cured product according to Application Example 9.

EFFECTS OF THE INVENTION

The composition according to the invention can form a cured product (e.g., coating or film) that exhibits excellent hygroscopicity, heat resistance, transparency, film-forming capability, and adhesion to glass. The cured product is not thermally deformed even under an environment at a temperature of more than 80°C, for example.

The composition according to the invention does not include a solvent. Accordingly, the cured product of the composition does not include a solvent. Therefore, when incorporating the cured product in an electronic device, entrance of moisture due to pinholes, deformation of the electronic device, or the like that may occur when a solvent remains in the cured product can be prevented.

The cured product is useful as a moisture getter for electronic devices (e.g., organic EL device). When the cured product exhibits excellent transparency, the cured product may be used for a top-emission organic EL device.

BRIEF DESCRIPTION OF DRAWINGS

FIG. 1 is a diagram schematically illustrating the cross section of an organic EL device according to a first embodiment of the invention.

FIG. 2 is a diagram schematically illustrating the cross section of an organic EL device according to a second embodiment of the invention.

FIG. 3 illustrates the $^1$H-NMR spectrum of tri(2,2-bis(allyloxymethyl)-1-butoxy)aluminum.

FIG. 4 illustrates the $^1$H-NMR spectrum of tri(2-(2-(vinyloxyethoxy)ethoxy)aluminum.

DESCRIPTION OF EXEMPLARY EMBODIMENTS

Preferred embodiments of the invention are described in detail below. Note that the invention is not limited to the following embodiments. The invention includes various modifications that may be implemented without departing from the scope of the invention.

1. Composition

A composition according one embodiment of the invention includes (A) a compound shown by the following

general formula (1) (hereinafter may be referred to as "component (A)"), and (B) a compound shown by the following general formula (2) (hereinafter may be referred to as "component (B)").

$(R^1)nM$ (1)

wherein $R^1$ independently represent a group selected from a substituted or unsubstituted alkyl group, a substituted or unsubstituted alkenyl group, a substituted or unsubstituted alkynyl group, a substituted or unsubstituted cycloalkyl group, a substituted or unsubstituted aryl group, a substituted or unsubstituted carboxyl group, and a group shown by $R^3O$-, provided that at least one of $R^1$ represents a group that includes one or more unsaturated bonds, $R^3$ represents a group selected from a substituted or unsubstituted alkyl group, a substituted or unsubstituted alkenyl group, a substituted or unsubstituted alkynyl group, a substituted or unsubstituted cycloalkyl group, and a substituted or unsubstituted aryl group, n is an integer from 2 to 4 that is equal to a valence of M, and M represents an atom having a valence of 2 to 4.

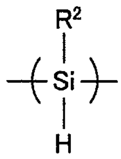 ···(2)

wherein $R^2$ represents an atom or a group selected from a hydrogen atom, a halogen atom, and an organic group.

The components of the composition according to one embodiment of the invention are described below.

1.1. Compound (A)

The composition according to one embodiment of the invention includes the compound (A) shown by the general formula (1) (hereinafter may be referred to as "component (A)"). The component (A) absorbs moisture (water) when the $R^1$-M bond contained therein reacts with moisture. A cured product that exhibits excellent hygroscopicity is obtained using the component (A). More specifically, when using a cured product of the composition according to one embodiment of the invention for absorbing moisture, the cured product must include an $R^1$-M bond. Therefore, the composition according to one embodiment of the invention must include an $R^1$-M bond.

$R^1$ in the general formula (1) independently represent a group selected from a substituted or unsubstituted alkyl group, a substituted or unsubstituted alkenyl group, a substituted or unsubstituted alkynyl group, a substituted or unsubstituted cycloalkyl group, a substituted or unsubstituted aryl group, a substituted or unsubstituted carboxyl group, and a group shown by $R^3O$-, provided that at least one of $R^1$ represents a group that includes one or more unsaturated bonds. $R^1$ preferably represents a group shown by $R^3O$-. $R^3$ preferably represents a group selected from a substituted or unsubstituted alkyl group, a substituted or unsubstituted alkenyl group, a substituted or unsubstituted alkynyl group, a substituted or unsubstituted cycloalkyl group, and a substituted or unsubstituted aryl group. The groups represented by $R^1$ and $R^3$ may be linear, cyclic, or branched. When $R^1$ or $R^3$ represents an alkenyl group or an alkynyl group, the position (and the number) of the double bond or triple bond are not particularly limited. $R^1$ may be arbitrarily selected from the above groups taking account of the properties of the target cured product. If $R^1$ represents a group selected from the above groups, the mutual solubility between the component (A) and a component (B) (described later) can be improved. This makes it possible to prevent phase separation even when the composition is allowed to stand, so that a composition that exhibits excellent storage stability can be obtained.

n in the general formula (1) is an integer from 2 to 4 (i.e., a plurality of $R^1$ are present). $R^1$ may be either the same or different, but at least one of $R^1$ represents a group that includes one or more unsaturated bonds. The position and the number of unsaturated bond(s) are not particularly limited. When at least one of $R^1$ represents a group that includes one or more unsaturated bonds, an addition reaction (i.e., hydrosilylation reaction) with the unsaturated bonds present in $R^1$ occurs when cleavage of the Si-H bond present in the component (B) occurs. The component (A) can thus be bonded to the component (B).

It is more preferable that all of $R^1$ include an unsaturated bond. If all of $R^1$ include an unsaturated bond, the group represented by $R^1$ is efficiently bonded to the component (B). This makes it possible to suppress formation of a hydrolyzate ($R^1H$) (e.g., alkane or alcohol) derived from the group represented by $R^1$.

It is preferable that the unsaturated bond included in the group represented by $R^1$ be a carbon-carbon unsaturated bond. If the unsaturated bond in the group represented by $R^1$ is a carbon-carbon unsaturated bond, the carbon-carbon unsaturated bond reacts with the Si-H bond, so that a stable Si-C bond can be formed. As a result, formation of a hydrolyzate ($R^1H$) (e.g., alkane or alcohol) derived from $R^1$ is suppressed even when the component (A) is hydrolyzed.

The carbon-carbon unsaturated bond present in the group represented by $R^1$ is more preferably an ethylenically

unsaturated bond. Since an ethylenically unsaturated bond exhibits excellent reactivity with the Si-H bond, the reaction between the component (A) and the component (B) proceeds easily. This makes it possible to reduce the content of the group represented by $R^1$ that remains without reacting with the component (B), and suppress formation of a hydrolyzate ($R^1H$) (e.g., alkane or alcohol) derived from $R^1$.

The number of carbon atoms of the group represented by $R^1$ is preferably 6 to 30, more preferably 10 to 20, and particularly preferably 12 to 20. A hydrolyzate ($R^1H$) (e.g., alkane or alcohol) derived from the group represented by $R^1$ is formed when the compound shown by the general formula (1) is hydrolyzed. If the number of carbon atoms of the group represented by $R^1$ is within the above range, the hydrolyzate has a higher boiling point. Therefore, outgas from the hydrolyzate is hardly generated, and a homogenous mixture of the component (A) and the component (B) is easily formed. If the number of carbon atoms of the group represented by $R^1$ is within the above range, the hydrolyzate ($R^1H$) does not serve as a plasticizer for the cured product. This prevents an increase in thermal fluidity of the cured product. The boiling point of the hydrolyzate under atmospheric pressure is preferably 200°C or more, and more preferably 250°C or more. If the boiling point of the hydrolyzate is 200°C or more, it is possible to suppress the hydrolyzate from diffusing into an electronic device, for example.

$R^1$ is more preferably a group that includes two or more unsaturated bonds since the crosslinked structure of the reaction product with the component (B) can be maintained even after the component (A) has been hydrolyzed.

Examples of the alkyl group include a hexyl group, a heptyl group, an octyl group, a nonyl group, a decyl group, an undecyl group, a dodecyl group, a hexadecyl group, a tetramethylhexadecyl group, an octadecyl group, and the like.

Examples of the alkenyl group include an octenyl group, a dodecenyl group, an octadecenyl group, an allyl group, and the like.

Examples of the alkynyl group include an ethynyl group, a propynyl group, a phenylethynyl group, and the like.

Examples of the cycloalkyl group include a cyclohexyl group and the like.

Examples of the aryl group include a phenyl group, a benzyl group, and the like.

M in the general formula (1) represents an atom having a valence of 2 to 4. Examples of the atom having a valence of 2 to 4 include group 2 elements, group 4 elements, group 12 elements, group 13 elements, and group 14 elements in the IUPAC periodic table. Specific examples of the atom having a valence of 2 to 4 include Al, B, Mg, Zn, Ti, Zr, Si, and the like. Among these, Al is preferable since Al exhibits excellent hygroscopicity, and can maintain transparency without being colored after the component (A) has been hydrolyzed by absorbing moisture.

The compound shown by the general formula (1) is preferably a compound shown by the following general formula (4).

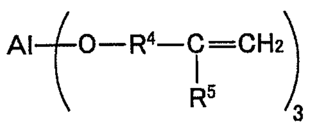
···(4)

wherein $R^4$ independently represent a divalent organic group. The divalent organic group is preferably a saturated or unsaturated alkylene group or a saturated or unsaturated oxyalkylene group. $R^5$ independently represent a hydrogen atom or a monovalent organic group. The monovalent organic group is preferably a group selected from a substituted or unsubstituted alkenyl group, a substituted or unsubstituted alkynyl group, a substituted or unsubstituted cycloalkyl group, a substituted or unsubstituted aryl group, and a substituted or unsubstituted carboxyl group. $R^4$ and $R^5$ may be arbitrarily selected depending on the properties of the target cured product. If the group represented by $R^4$ or the group represented by $R^5$ includes an ether structure, the mutual solubility between the component (A) and the component (B) is further improved. This may make it possible to arbitrarily control the content ratio of the component (A) to the component (B) depending on the properties required for the cured product. Moreover, since the compound shown by the general formula (4) includes an ethylenically unsaturated bond, a reaction with the Si-H bond easily occurs. This makes it possible to significantly reduce production of a low-molecular-weight component that is formed due to hydrolysis of the component (A).

Specific examples of the compound shown by the general formula (4) include tri(2,2-bis(allyloxymethyl)-1-butoxy)aluminum, tri(2-(2-(vinyloxyethoxy)ethoxy)aluminum, tri(2-dodecenoxy)aluminum, and the like.

Tri(2,2-bis(allyloxymethyl)-1-butoxy)aluminum and tri(2-(2-(vinyloxyethoxy)ethoxy)aluminum are novel compounds that exhibit an excellent moisture-absorbing effect. Tri (2,2-bis(allyloxymethyl)-1-butoxy)aluminum has a structure shown by the following formula (5), and tri(2-(2-(vinyloxyethoxy)ethoxy)aluminum has a structure shown by the following formula (6). The boiling point of an alcohol that is formed when tri(2,2-bis(allyloxymethyl)-1-butoxy)aluminum shown by the formula (5) reacts with moisture is 258°C under atmospheric pressure. Specifically, tri(2,2-bis(allyloxymethyl)-1-butoxy)aluminum produces an alcohol that is less volatilized under a usage environment. Since the compound shown by the formula (5) and the compound shown by the formula (6) exhibit excellent mutual

solubility with the compound (B), a transparent composition can be produced.

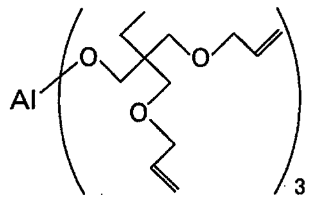

...(5)

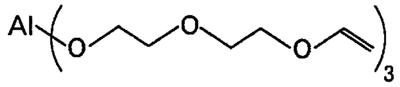

...(6)

The compound shown by the formula (5) is produced as described below.

Triisobutylaluminum is gradually added to trimethylolpropane diallyl ether (2.8 to 3.5 equivalents) with stirring, and the mixture is reacted at 0 to 150°C for 1 to 4 hours. The resulting product is subjected to a post-treatment by a normal method to easily obtain the compound shown by the formula (5). When producing the compound shown by the formula (5), a component derived from the reaction mixture or a by-product may be inevitably mixed into the product. Note that the product may be directly applied as long as the product includes the compound shown by the formula (5) as the main component.

The compound shown by the formula (6) is produced as described below.

Triisopropoxyaluminum is dissolved in dry toluene. After the addition of 2-(2-vinyloxyethoxy)ethanol (3 to 4 equivalents) to the solution, the mixture is reacted at 90°C for a given time. The resulting product is subjected to a post-treatment by a normal method to easily obtain the compound shown by the formula (6). When producing the compound shown by the formula (6), a component derived from the reaction mixture or a by-product may be inevitably mixed into the product. Note that the product may be directly applied as long as the product includes the compound shown by the formula (6) as the main component.

The content of the component (A) in the composition according to one embodiment of the invention is preferably 10 to 90 mass%, and more preferably 50 to 80 mass%, based on the total amount (=100 mass%) of the composition. If the content of the component (A) is within the above range, the resulting cured product effectively exhibits a moisture-absorbing effect. If the content of the component (A) is within the above range, the composition exhibits moderate viscosity (described below). This makes it possible to improve workability (e.g., film-forming capability) when forming the cured product.

1.2. Compound (B)

The composition according to one embodiment of the invention includes the compound (B) shown by the general formula (2). The compound (B) may be a polymer that includes a structure shown by the general formula (2), or may be a monomer that includes a structure shown by the general formula (2).

When curing the composition according to one embodiment of the invention that includes the component (A) and the component (B), cleavage of the Si-H bond present in the component (B) occurs, so that an addition reaction (i.e., hydrosilylation reaction) with the unsaturated bond present in the component (A) occurs. A cured product in which the component (A) is immobilized on the component (B) can thus be formed. This prevents a situation in which a low-molecular-weight hydrolyzate is formed when the component (A) has absorbed moisture. This makes it possible to suppress volatilization of the hydrolyzate. Note that the expression "low-molecular-weight" used herein refers to a molecular weight of about 300 or less.

When the component (B) is a monomer, the component (B) is polymerized and also copolymerized with the component (A) when curing the composition according to one embodiment of the invention. A cured product in which the component (A) is immobilized on (bonded to) the component (B) can thus be formed. When the component (B) is a bi- or higher functional monomer, a crosslinking reaction occurs even if the component (B) is not polymerized, so that a cured product in which the component (A) and the component (B) are bonded to each other can be formed. This makes it possible to prevent a situation in which a low-molecular-weight hydrolyzate is formed when the component (A) has absorbed moisture. It is thus possible to suppress volatilization of the hydrolyzate.

The component (B) is more preferably a compound that includes a structure shown by the following general formula (3).

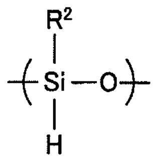

···(3)

wherein $R^2$ represents an atom or a group selected from a hydrogen atom, a halogen atom, and an organic group.

$R^2$ in the general formulas (2) and (3) represents an atom or a group selected from a hydrogen atom, a halogen atom, and an organic group. $R^2$ may be arbitrarily selected from the above group taking account of the properties of the target cured product. If $R^2$ represents an atom or a group selected from a hydrogen atom, a halogen atom, and an organic group, the mutual solubility between the compound (A) and the compound (B) can be improved. This makes it possible to produce a composition that does not undergo phase separation when the composition is allowed to stand, and exhibits excellent storage stability. Examples of the organic group include a substituted or unsubstituted alkyl group, a substituted or unsubstituted alkenyl group, a substituted or unsubstituted alkynyl group, a substituted or unsubstituted cycloalkyl group, and a substituted or unsubstituted aryl group. The organic group may include a halogen atom or an ether group. The organic group may be linear, cyclic, or branched. When the organic group is an alkenyl group or an alkynyl group, the position and the number of double bonds or triple bonds are not particularly limited. The organic group preferably has 1 to 30 carbon atoms. If $R^2$ represents an organic group having 1 to 30 carbon atoms, the mutual solubility between the compound (A) and the compound (B) may be further improved, and a composition that exhibits even better storage stability may be produced.

Examples of the alkyl group include a hexyl group, a heptyl group, an octyl group, a nonyl group, a decyl group, an undecyl group, a dodecyl group, a hexadecyl group, a tetramethylhexadecyl group, an octadecyl group, a 3,3,3-trifluoropropyl group, and the like.

Examples of the alkenyl group include a vinyl group, an octenyl group, a dodecenyl group, an octadecenyl group, an allyl group, and the like.

Examples of the alkynyl group include an ethynyl group, a propynyl group, a phenylethynyl group, and the like.

Examples of the cycloalkyl group include a cyclohexyl group and the like.

Examples of the aryl group include a phenyl group, a benzyl group, and the like.

The component (B) is preferably a polymer that includes the repeating unit shown by the general formula (2), and more preferably a polysiloxane that includes the repeating unit shown by the general formula (3). Examples of the component (B) include polydihydrogensiloxane, poly(methylhydrogensiloxane), poly(ethylhydrogensiloxane), poly(phenylhydrogensiloxane), polyphenyl(dimethylhydrogensiloxy)siloxane, a poly[(methylhydrogensiloxane)(dimethylsiloxane)] copolymer, a poly[(methylhydrogensiloxane)(ethylmethylsiloxane)] copolymer, a poly[(methylhydrogensiloxane)(diethylsiloxane)] copolymer, a poly[(methylhydrogensiloxane)(hexylmethylsiloxane)] copolymer, a poly[(methylhydrogensiloxane)(octylmethylsiloxane)] copolymer, a poly[(methylhydrogensiloxane)(octadecylmethylsiloxane)] copolymer, a poly[(methylhydrogensiloxane)(phenylmethylsiloxane)] copolymer, a poly[(methylhydrogensiloxane)(diethoxysiloxane)] copolymer, a poly[(methylhydrogensiloxane)(dimethoxysiloxane)] copolymer, a poly[(methylhydrogensiloxane)(3,3,3-trifluoropropylmethylsiloxane)] copolymer, a poly[(dihydrogensiloxane)(2-fluoroethoxymethylsiloxane)] copolymer, a poly[(dihydrogensiloxane)((2-methoxyethoxy)methylsiloxane)] copolymer, a poly[(dihydrogensiloxane)(phenoxymethylsiloxane)] copolymer, a poly[(dihydrogensiloxane)(naphthylmethylsiloxane)] copolymer, a poly[(dihydrogensiloxane)(4-chlorophenylmethylsiloxane)] copolymer, a poly[(dihydrogensiloxane)((4-methoxyphenyl)dimethylsiloxane)] copolymer, and the like.

When the component (B) is a polymer, the weight average molecular weight of the component (B) is preferably 300 to 100,000, and more preferably 1,000 to 50,000. Note that the term "weight average molecular weight" used herein refers to a polystyrene-reduced weight average molecular weight determined by gel permeation chromatography (GPC). If the weight average molecular weight of the component (B) is within the above range, it is possible to prevent a situation in which a low-molecular-weight hydrolyzate is formed when the component (A) has absorbed moisture. This makes it possible to suppress volatilization of the hydrolyzate. If the weight average molecular weight of the component (B) is within the above range, the resulting composition exhibits moderate viscosity. This makes it possible to improve the workability (e.g., film-forming capability) of the composition according to one embodiment of the invention.

When the component (B) is not a polymer, the component (B) may be an arbitrary compound that includes the structure shown by the general formula (2). Examples of the compound that includes the structure shown by the general formula (2) include diphenyl-t-butylhydrosilane, tribenzylsilane, and the like.

The functions of the component (B) are described below (see (1) to (4)).

(1) The component (B) reacts with the component (A) when curing the composition according to one embodiment of the invention, so that the cured product in which the component (A) is immobilized on (bonded to) the component

(B) can be formed. Therefore, when a moiety derived from the component (A) in the cured product reacts with moisture, a medium-molecular-weight or high-molecular-weight compound (e.g., alcohol or alkane) with low volatility is formed as a hydrolyzate instead of a low-molecular-weight compound (e.g., alcohol or alkane) with high volatility. This makes it possible to suppress the hydrolyzate from volatilizing and diffusing into an electronic device.

(2) The component (B) makes it unnecessary to add a solvent to the composition. Since the component (B) is voluntarily mixed with the component (A), there is no need to use a solvent for dissolving the component (A). This can prevent the above problems that may occur when a solvent remains in the cured product.

(3) The component (B) reduces the thermal fluidity of the cured product. The component (B) reacts with the component (A) when curing the composition according to one embodiment of the invention, so that a cured product in which the component (A) is immobilized on (bonded to) the component (B) can be formed. The cured product thus formed exhibits reduced thermal fluidity while maintaining the moisture absorption capability of the component (A).

(4) Since the component (B) is voluntarily mixed with the component (A), it is possible to improve the transparency of a cured product obtained by curing the composition.

The content of the component (B) in the composition according to one embodiment of the invention is preferably 10 to 90 mass%, and more preferably 20 to 50 mass%, based on the total amount (=100 mass%) of the composition. If the content of the component (B) is within the above range, an excellent cured product can be formed without impairing the above functions.

1.3. Catalyst (C)

The composition according to one embodiment of the invention may include (C) a catalyst (hereinafter may be referred to as "component (C)") in order to promote a hydrosilylation reaction between the compound (A) and the compound (B). The catalyst (C) is preferably a platinum complex or a rhodium complex. Examples of the platinum complex include a carbonylcyclovinylmethylsiloxane-platinum complex, a platinum-octanal/octanol complex, a cyclovinylmethylsiloxane-platinum complex, a carbonyldivinylmethyl-platinum complex, a divinyltetramethyldisiloxane-platinum complex, and the like. Examples of the rhodium complex include tris(dibutylsulfide)rhodium trichloride and the like.

The content of the component (C) in the composition according to one embodiment of the invention is preferably 0.0001 to 1 mass%, and more preferably 0.001 to 0.1 mass%, based on the total amount (=100 mass%) of the composition. If the content of the component (C) is within the above range, a hydrosilylation reaction between the compound (A) and the compound (B) can be promoted without impairing the properties (e.g., hygroscopicity and transparency) of a cured product obtained by curing the composition.

1.4. Content ratio ($W_A/W_B$)

The content ratio ($W_A/W_B$) of the content ($W_A$) of the component (A) to the content ($W_B$) of the component (B) in the composition according to one embodiment of the invention is preferably 0.18 to 5, more preferably 1 to 5, and particularly preferably 1 to 4. If the content ratio ($W_A/W_B$) is within the above range, the resulting cured product has a sufficient moisture absorption capacity, and exhibits excellent heat resistance and adhesion to glass. If the content ratio ($W_A/W_B$) is less than 0.18, the resulting cured product may not sufficiently functions as a moisture absorber due to a decrease in moisture absorption capacity, and tends to exhibit a poor film-forming capability or poor adhesion to glass. If the content ratio ($W_A/W_B$) exceeds 5, the resulting cured product tends to exhibit poor heat resistance, film-forming capability, or adhesion to glass, in spite of having a sufficient moisture absorption capacity.

1.5. Additive

The composition according to one embodiment of the invention may include a moisture absorbent other than the component (A). The moisture absorbent other than the component (A) is not particularly limited as long as the moisture absorbent has mutual solubility with the component (B). Examples of the moisture absorbent other than the component (A) include trihexyloxyaluminum, trioctyloxyaluminum, tridecyloxyaluminum, tridodecyloxyaluminum, trioctadecyloxyaluminum, tridecyloxyborane, tridodecyloxyborane, trioctadecyloxyborane, tridecylaluminum, tridodecylaluminum, and the like.

The composition according to one embodiment of the invention may include a polymerizable compound other than the component (B). Examples of the polymerizable compound other than the component (B) include acryl group-containing polymerizable compounds such as (meth)acrylic acid, methyl methacrylate (MMA), ethyl methacrylate (EMA), propyl methacrylate (PMA), butyl methacrylate (BMA), ethylhexyl methacrylate (EHMA), trimethoxysilylpropyl methacrylate (TMSPMA), t-butyl methacrylate (t-BMA), hydrogenated butadiene methacrylate ("L1253" manufactured by Kuraray Ltd.), methyl acrylate, ethyl acrylate, and benzyl acrylate; vinyl ether group-containing polymerizable compounds such

as triethylene glycol divinyl ether; vinyl group-containing polymerizable compounds such as vinylcyclohexene monoxide; polymerizable compounds that contain a cyclic ether group such as an oxetanyl group or an oxiranyl group; and the like. These polymerizable compounds may be used either individually or in combination.

The composition according to one embodiment of the invention may further include a stabilizer. The stabilizer suppresses gelation of the composition according to one embodiment of the invention (i.e., the composition exhibits excellent storage stability). Examples of the stabilizer include sulfur compounds, phosphorus compounds, alkyne compounds, maleic acid derivatives, nitrogen-containing compounds, and the like. Specific examples of the stabilizer include benzothiazole, tris(2,4-di-t-butylphenyl)phosphite, 1-ethynyl-1-cyclohexanol, diethyl maleate, N-methylpyrrolidone, 1,3-dimethyl-2-imidazolidone, N-vinyl-epsilon-caprolactam (all available from Tokyo Kasei Kogyo Co., Ltd.), and the like. These stabilizers may be used either individually or in combination. Since the gelation time of the composition can be adequately controlled by utilizing these stabilizers, a composition that exhibits excellent storage stability can be obtained, and an excellent cured product can be produced.

The stabilizer is preferably used in an amount of 0.01 to 5 parts by mass, more preferably 0.05 to 2 parts by mass, and particularly preferably 0.05 to 1 parts by mass, based on the total mass (=100 parts by mass) of the composition excluding the stabilizer. If the amount of the stabilizer is within the above range, the composition has a sufficient pot life at normal temperature due to excellent storage stability, and the curability of the composition does not deteriorate.

The composition according to one embodiment of the invention may further include a thermally-conductive filler in order to improve thermal conductivity. Since an organic EL lighting device that includes a plurality of organic EL devices, for which the composition according to one embodiment of the invention may be used, generates heat, the emission properties (e.g., luminance or emission efficiency) of the device may be adversely affected due to an increase in temperature. If the composition includes the thermally-conductive filler, it is possible to increase the heat dissipation capability so that the device can be protected from moisture and a problem that may occur due to generation of heat.

A known filler such as inorganic particles may be used as the thermally-conductive filler. When using inorganic particles as the thermally-conductive filler, it is possible to increase the thermal conductivity of a cured product formed using the composition according to one embodiment of the invention. Moreover, since the inorganic particles adsorb a component (i.e., hydrolyzate) that is formed when the component (A) is decomposed as a result of absorbing moisture, the hydrolyzate remains in the cured product. This prevents the hydrolyzate from serving as a plasticizer for the cured product. Therefore, the cured product is not thermally deformed even at a temperature of more than 80°C, for example. The inorganic particles also improve the mechanical strength and the moisture absorption capability of the cured product.

Note that the term "inorganic particles" used herein refers to particles formed of a compound other than an organic compound that includes a carbon atom in the basic skeleton, but includes particles formed of a carbon allotrope.

The inorganic particles are preferably formed of a metal oxide or a metal nitride. Examples of the metal oxide include silica (including silica gel), smectite, zeolite, alumina, titanium oxide, zirconia, magnesia, various glass powders used as a heat-dissipating material, and the like. Examples of the metal nitride include boron nitride, aluminum nitride, silicon nitride, and the like. Silicon carbide, boron carbide, or activated carbon may also be used as the inorganic particles. The inorganic particles are preferably at least one kind of particles selected from alumina particles, silica particles, boron nitride particles, aluminum nitride particles, silicon nitride particles, magnesia particles, silicon carbide particles, boron carbide particles, and smectite particles, from the viewpoint of reducing thermal fluidity. The inorganic particles are particularly preferably alumina particles and/or boron nitride particles due to excellent thermal conductivity. These inorganic particles may be used either individually or in combination.

The silica particles used in one embodiment of the invention may be produced by a known method. For example, the silica particles may be produced by the silica particle dispersion production process disclosed in JP-A-2003-109921 or JP-A-2006-80406. The silica particles may also be produced by removing an alkali from an alkali silicate aqueous solution. Examples of the alkali silicate aqueous solution include a sodium silicate aqueous solution (water glass), an ammonium silicate aqueous solution, a lithium silicate aqueous solution, a potassium silicate aqueous solution, and the like. Examples of the ammonium silicate include silicates of ammonium hydroxide and tetramethylammonium hydroxide.

It is preferable that the silica particles used in one embodiment of the invention be hydrophobized. Note that the term "hydrophobization" used herein means that the hydrogen atom of a silanol group (-SiOH) included in the silica particles is substituted with a hydrophobic group (-R) (e.g., alkyl group). The silanol groups present on the surface of the silica particles tend to decrease the moisture absorption capability of a cured product formed using the composition according to one embodiment of the invention via a reaction with the component (A). If the silanol groups present on the surface of the silica particles are hydrophobized, it is possible to suppress a decrease in moisture absorption capability of the cured product. Moreover, it is possible to improve the dispersibility of the silica particles during mixing.

The shape of the inorganic particles is not particularly limited, and may be spherical, ellipsoidal, or polygonal. The inorganic particles may be porous particles or core-shell particles.

The average particle size of the inorganic particles is preferably 5 to 5000 nm, more preferably 5 to 2000 nm, still more preferably 5 to 500 nm, and particularly preferably 5 to 100 nm. If the average particle size of the inorganic particles is within the above range, it is possible to prevent thermal deformation of a cured product formed using the

composition according to one embodiment of the invention. In particular, a cured product that exhibits excellent transparency can be formed when the inorganic particles have an average particle size of 5 to 100 nm. If the average particle size of the inorganic particles is within the above range, it is easy to provide the composition with moderate viscosity (described below). This makes it possible to improve workability (e.g., applicability) when forming a cured product. If the average particle size of the inorganic particles is within the above range, the inorganic particles have a surface area sufficient for absorbing a hydrolyzate. This makes it possible to suppress thermal deformation of the cured product.

The average particle size of the inorganic particles is preferably calculated from the specific surface area measured by the BET method, but may also be determined by another known method.

The average particle size of the inorganic particles may also be determined by collecting a cured product formed using the composition according to one embodiment of the invention, cutting the cured product, and observing the section of the cured product using an electron microscope or the like. This method makes it possible to determine the average particle size of the inorganic particles even after the cured product has been formed.

The content of the inorganic particles in the composition according to one embodiment of the invention is preferably 0.1 to 80 mass%, and more preferably 20 to 60 mass%, based on the total amount (=100 mass%) of the composition, from the viewpoint of improving the thermal conductivity of the resulting cured product. When it is desired to improve the transparency of the resulting cured product, the content of the inorganic particles in the composition is preferably 0.1 to 20 mass%, and more preferably 0.1 to 10 mass%, based on the total amount (=100 mass%) of the composition. If the content of the inorganic particles is 0.1 mass% or more, the resulting cured product is not thermally deformed.

1.6. Production of composition

The composition according to one embodiment of the invention may be produced by mixing the component (A), the component (B), the optional component (C), and optional additives. The components may be mixed by an arbitrary method. For example, the composition according to one embodiment of the invention may be produced by slowly adding the component (A) to the component (B) (optionally together with the component (C) and optional additives) with stirring to dissolve the component (A).

1.7. Properties and applications of composition

The composition according to one embodiment of the invention preferably has a viscosity at 20°C of 50 to 500,000 cP. If the composition has a viscosity within the above range, the composition can be directly applied to a device substrate by an ODF method or a dispensing method, and cured on the device substrate. This eliminates the need for preparing a formed product (e.g., film) using the composition according to one embodiment of the invention, and incorporating the formed product in the device. Thus, the process can be simplified. When a photoacid generator or the like is added to the composition according to one embodiment of the invention so that the composition exhibits photosensitivity, a fine pattern can be formed. Note that the viscosity of the composition is a value measured by the falling needle method.

Since the composition according to one embodiment of the invention can form a cured product that includes the component (A), the composition may be used for a moisture-absorbing application. The composition according to one embodiment of the invention may be used as a moisture absorber for an organic EL device, an organic TFT, an organic solar cell, an organic CMOS sensor, or the like, and may particularly preferably be used as a moisture absorber for an organic EL device.

2. Cured product

The term "cured product" used herein refers to a product that is produced by forming or molding the composition into a the desired shape, and applying heat or light to the composition so that the resulting product has viscosity or hardness higher than that of the composition.

The cured product according to one embodiment of the invention may be obtained by applying the composition to a substrate (e.g., glass substrate), and curing the composition by applying heat or light, for example. The cured product includes the component (A) that includes the $R^1$-M bond. The $R^1$-M bond reacts with moisture to absorb moisture. Therefore, the cured product needs to substantially include the $R^1$-M bond when using the cured product for a moisture-absorbing application.

The composition may be applied using a spin coater, a roll coater, a spray coater, a dispenser, an inkjet apparatus, or the like.

The curing temperature is preferably 40 to 250°C, and more preferably 50 to 150°C, for example. When using the component (C), an excellent cured product can be produced by heating the composition at a temperature within the above range.

The shape of the cured product is not particularly limited, but may be in the shape of a film, for example. When the cured product is in the shape of a film, the thickness of the film is preferably 5 to 100 micrometers, for example.
The content of the component (A) in the cured product according to one embodiment of the invention is preferably 10 to 90 mass%, and more preferably 50 to 80 mass%, based on the total mass (100 mass%) of the cured product. If the content of the component (A) is within the above range, the cured product exhibits a sufficient moisture-absorbing effect. Moreover, the cured product can be provided with transparency due to an improvement in film-forming capability.

3. Electronic device

An electronic device according to one embodiment of the invention includes the cured product according to one embodiment of the invention. The cured product may be provided in an arbitrary electronic device that is sensitive to moisture. An example of an organic EL device (i.e., representative sealed electronic device) is described below with reference to the drawings.
FIG. 1 is a diagram schematically illustrating the cross section of an organic EL device 100 according to a first embodiment of the invention. As illustrated in FIG. 1, the organic EL device 100 includes an organic EL layer 10, a structure 20 that receives the organic EL layer 10 and blocks air, and an absorber layer 30 formed in the structure 20.
The organic EL layer 10 has a structure in which an organic emitting material layer formed of an organic material is held between a pair of electrodes that are disposed opposite to each other. For example, the organic EL layer 10 may have a known structure that includes an anode, a carrier (hole) transporting agent, an emitting layer, and a cathode.
The absorber layer 30 is the cured product of the composition. The absorber layer 30 is spaced from the organic EL layer 10 (see FIG. 1).
In FIG. 1, the structure 20 includes a substrate 22, a sealing cap 24, and an adhesive 26. The substrate 22 may be a glass substrate or the like. The sealing cap 24 may be a structure formed of glass or the like. The structure 20 may have an arbitrary structure that can receive the organic EL layer 10.
FIG. 2 is a diagram schematically illustrating the cross section of an organic EL device 200 according to a second embodiment of the invention. As illustrated in FIG. 2, the organic EL device 200 differs from the organic EL device 100 in that the absorber layer 30 is formed in the structure 20 so as to adhere to the organic EL layer 10. Since the absorber layer 30 is formed using the cured product in which only a small amount of a volatile component remains or is formed, the absorber layer 30 does not impair the display characteristics of the organic EL layer 10. The absorber layer 30 prevents moisture from entering the organic EL layer 10, and protects the organic EL layer 10.

4. Examples

The invention is further described below by way of examples. Note that the invention is not limited to the following examples.

4.1. Compound (A)

4.1.1. Synthesis of tri(2,2-bis(allyloxymethyl)-1-butoxy)aluminum

A 500 ml three-necked flask was charged with 162.0 g (756 mmol) of trimethylolpropane diallyl ether ("NEOALLYL T-20" manufactured by Daiso Co., Ltd.). 50.0 g (252.7 mmol) of triisobutylaluminum was slowly added dropwise to the flask with stirring in a glove box, and the mixture was stirred for 1 hour. The mixture was then stirred at 120°C for 90 minutes. Unreacted raw materials were evaporated from the mixture while reducing pressure using a vacuum pump and keeping the temperature of the mixture at 120°C. The residue was then cooled to room temperature to obtain 164.0 g of tri(2,2-bis(allyloxymethyl)-1-butoxy)aluminum (hereinafter referred to as "TMDE-3") as a transparent colorless oily product. The yield was quantitative.
FIG 3 illustrates the $^1$H-NMR spectrum of the resulting TMDE-3. In the $^1$H-NMR measurement, toluene-d8 (peak(delta): around 2.1) was used as the internal standard. It was confirmed that the resulting compound had the chemical structure shown by the formula (5) (see FIG. 3).
172.0 g of a mixture containing tri(2,2-bis(allyloxymethyl)-1-butoxy)aluminum (hereinafter referred to as "TMDE-3B") was obtained in the same manner as described above, except for changing the amount of trimethylolpropane diallyl ether to 162.0 g (756 mmol), and changing the amount of triisobutylaluminum to 60.0 g (303.2 mmol). As a result of $^1$H-NMR analysis, it was confirmed that TMDE-3B was a mixture containing a compound having the chemical structure shown by the formula (5).
194.0 g of a mixture containing tri(2,2-bis(allyloxymethyl)-1-butoxy)aluminum (hereinafter referred to as "TMDE-3C") was obtained in the same manner as described above, except for changing the amount of trimethylolpropane diallyl ether to 194.4 g (907 mmol), and changing the amount of triisobutylaluminum to 50.0 g (252.7 mmol). As a result of $^1$H-

NMR analysis, it was confirmed that TMDE-3C was a mixture containing a compound having the chemical structure shown by the formula (5).

The resulting tri(2,2-bis(allyloxymethyl)-1-butoxy)aluminum (TMDE-3) and mixtures containing TMDE-3 (TMDE-3B and TMDE-3C) were used as the component (A) in the examples and the comparative examples.

4.1.2. Synthesis of tri(2-(2-(vinyloxyethoxy)ethoxy)aluminum

In a 200 ml three-necked flask, 15.0 g (73.4 mmol) of triisopropoxyaluminum was dissolved in 45 ml of dry toluene with stirring under a dry nitrogen atmosphere. After the addition of 33.0 ml (257 mmol) of 2-(2-vinyloxyethoxy) ethanol to the solution, the mixture was allowed to stand at 90°C for 10 minutes. After evaporating 2-propanol from the mixture at a temperature of 90°C under a pressure of 13.3 kPa, unreacted 2-(2-vinyloxyethoxy)ethanol was evaporated under a pressure of 133 Pa. 32 g of tri(2-(2-(vinyloxyethoxy)ethoxy)aluminum (hereinafter referred to as "DEGV-3") was thus obtained as a transparent colorless oily product. The yield was quantitative.

FIG. 4 illustrates the $^1$H-NMR spectrum of the resulting DEGV-3. In the $^1$H-NMR measurement, toluene-d8 (peak(delta): around 2.1) was used as the internal standard. As illustrated in FIG. 4, it was confirmed that the resulting compound had the chemical structure shown by the formula (6).

The resulting tri(2-(2-(vinyloxyethoxy)ethoxy)aluminum (DEGV-3) was used as the component (A) in the examples.

4.2. Compound (B)

The following commercially-available compounds were used as the compound (B) in the examples and the comparative examples.
Polymethylhydrogensiloxane ("HMS-991" manufactured by AZmax Co., Ltd.)
Polyethylhydrogensiloxane ("HES-992" manufactured by AZmax Co., Ltd.)
Polyphenyl(dimethylhydrogensiloxy)siloxane ("HDP-111" manufactured by AZmax Co., Ltd.)

4.3. Catalyst (C)

The following commercially-available compounds were used as the catalyst (C) in the examples and the comparative examples.
Cyclovinylmethylsiloxane-platinum complex ("SIP6832.0" manufactured by AZmax Co., Ltd., methylvinylsiloxane content: 3 mass%)
Carbonyldivinylmethyl-platinum complex ("SIP6832.0" manufactured by AZmax Co., Ltd., vinylmethylcyclosiloxane content: 3 mass%)

4.4. Stabilizer

The following commercially-available compounds were used as the stabilizer in the examples and the comparative examples.
Benzothiazole (manufactured by Tokyo Kasei Kogyo Co., Ltd.)
Tris(2,4-di-t-butylphenyl)phosphite (manufactured by Tokyo Kasei Kogyo Co., Ltd.)
1-Ethynyl-1-cyclohexanol (manufactured by Tokyo Kasei Kogyo Co., Ltd.)
Diethyl maleate (manufactured by Tokyo Kasei Kogyo Co., Ltd.)
N-Methylpyrrolidone (manufactured by Tokyo Kasei Kogyo Co., Ltd.)
N-Vinyl-epsilon-caprolactam (manufactured by Tokyo Kasei Kogyo Co., Ltd.)

4.5. Additive

The following commercially-available compounds were used as the additive in the examples and the comparative examples.
Tridodecylaluminum ("TA0365" manufactured by Chemtura Corporation)
Polydimethylsiloxane ("DMS-T21" manufactured by AZmax Co., Ltd.)
Aluminum isopropoxide (manufactured by Sigma-Aldrich Japan K.K.)

4.6. Examples and comparative examples

4.6.1. Production of film

A film was produced by the following method (Examples 1 to 18 and Comparative Examples 1 to 5).

A given amount of a component corresponding to the compound (A) and a given amount of a component corresponding to the compound (B) were mixed and sufficiently stirred in a glove box at a dew point of -60°C or less and an oxygen concentration of 5 ppm or less to prepare a homogenous solution. After the addition of a given amount of the stabilizer, the mixture was stirred to prepare a homogenous solution. A given amount of the catalyst (C) was then added to the solution to obtain the compositions A to V shown in Table 1 or 2.

The resulting composition was applied to a glass substrate, and cured by heating at 80 or 100°C for 30 minutes, 1 hour, or 3 hours to form a film. The compositions of the compositions A to V are shown in Tables 1 and 2.

TABLE 1

| | | Example 1 | Example 2 | Example 3 | Example 4 | Example 5 | Example 6 |
|---|---|---|---|---|---|---|---|
| Composition | | A | B | C | D | E | F |
| Compound (A) | Type | TMDE-3 | TMDE-3 | TMDE-3 | TMDE-3 | TMDE-3 | TMDE-3 |
| | Amount (parts by mass) | 80 | 50 | 15 | 80 | 70 | 80 |
| Compound (B) | Type | PMHS | PMHS | PMHS | PEHS | PPMHS | PMHS |
| | Amount (parts by mass) | 20 | 20 | 85 | 20 | 30 | 20 |
| Catalyst (C) | Type | Cyclovinylmethylsiloxane-platinum complex | Cyclovinylmethylsiloxane-platinum complex | Cyclovinylmethylsiloxane-platinum complex | Cyclovinylmethylsiloxane-platinum complex | Cyclovinylmethylsiloxane-platinum complex | Carbonylvinylmethyl-platinum complex |
| | Amount (parts by mass) | 0.1 | 0.1 | 0.1 | 0.1 | 0.1 | 0.1 |
| Additive | Type | | TD-3 | | | | |
| | Amount (parts by mass) | | 30 | | | | |
| Content ratio ($W_A/W_B$) | | 4.0 | 2.5 | 0.18 | 4.0 | 2.3 | 4.0 |
| Curing conditions | | 80°C: 1 hour | 80°C: 1 hour | 80°C: 1 hour | 80°C: 1 hour | 80°C: 1 hour | 80°C: 1 hour |
| Evaluation results | Absorption rate (%) | 50 | 55 | 30 | 50 | 45 | 50 |
| | Thermal fluidity | Good | Good | Good | Good | Good | Good |
| | Transparency | Good | Good | Good | Good | Good | Good |
| | Film-forming capability | Good | Good | Good | Good | Good | Good |
| | Adhesion to glass | Good | Good | Good | Good | Good | Good |
| | Gelation time (room temperature) | 30 minutes | 120 minutes | 30 minutes | 30 minutes | 20 minutes | 30 minutes |

TABLE 1 (continued)

| | | Comparative Example 1 | Comparative Example 2 | Comparative Example 3 | Comparative Example 4 | Comparative Example 5 |
|---|---|---|---|---|---|---|
| Composition | | G | H | I | J | K |
| Compound (A) | Type | | | TMDE-3 | | |
| | Amount (parts by mass) | | | 80 | | |
| Compound (B) | Type | PMHS | PMHS | | PMHS | PMHS |
| | Amount (parts by mass) | 20 | 20 | | 20 | 50 |
| Catalyst (C) | Type | Cyclovinylmethylsiloxane-platinum complex | Cyclovinylmethylsiloxane-platinum complex | Cyclovinylmethylsiloxane-platinum complex | Cyclovinylmethylsiloxane-platinum complex | Cyclovinylmethylsiloxane-platinum complex |
| | Amount (parts by mass) | 0.1 | 0.1 | 0.1 | 0.1 | 0.1 |
| Additive | Type | CaO | BaO | PMS | TD-3 | (i-PrO)3Al |
| | Amount (parts by mass) | 80 | 80 | 20 | 80 | 50 |
| Content ratio ($W_A/W_B$) | | - | - | - | - | - |
| Curing conditions | | 80°C: 1 hour | 80°C: 1 hour | 80°C: 1 hour | 80°C: 1 hour | 80°C: 1 hour |
| Evaluation results | Absorption rate (%) | Could not be measured | Could not be measured | Could not be measured | Could not be measured | Could not be measured |
| | Thermal fluidity | Could not be measured | Could not be measured | Could not be measured | Could not be measured | Could not be measured |
| | Transparency | Could not be measured | Could not be measured | Could not be measured | Could not be measured | Could not be measured |
| | Film-forming capability | Could not be measured | Could not be measured | Could not be measured | Could not be measured | Could not be measured |
| | Adhesion to glass | Could not be measured | Could not be measured | Could not be measured | Could not be measured | Could not be measured |
| | Gelation time (room temperature) | 1 week or more | 1 week or more | 1 week or more | 1 week or more | 1 week or more |

TABLE 2

| | | Example 7 | Example 8 | Example 9 | Example 10 | Example 11 | Example 12 |
|---|---|---|---|---|---|---|---|
| Composition | | L | M | N | O | P | Q |
| Compound (A) | Type | TMDE-3 | TMDE-3 | TMDE-3 | TMDE-3 | TMDE-3 | TMDE-3 |
| | Amount (parts by mass) | 50 | 50 | 50 | 50 | 50 | 50 |
| Compound (B) | Type | PMHS | PMHS | PMHS | PMHS | PMHS | PMHS |
| | Amount (parts by mass) | 50 | 50 | 50 | 50 | 50 | 50 |
| Catalyst (C) | Type | Cyclovinylmethylsiloxane-platinum complex | Cyclovinylmethylsiloxane-platinum complex | Cyclovinylmethylsiloxane-platinum complex | Cyclovinylmethylsiloxane-platinum complex | Cyclovinylmethylsiloxane-platinum complex | Cyclovinylmethylsiloxane-platinum complex |
| | Amount (parts by mass) | 0.1 | 0.1 | 0.1 | 0.1 | 0.1 | 0.1 |
| Additive | Type | BT | TDBPP | ECHO | DEM | NMP | VC |
| | Amount (parts by mass) | 3 | 0.2 | 0.5 | 2 | 0.5 | 0.5 |
| Content ratio ($W_A/W_B$) | | 1.0 | 1.0 | 1.0 | 1.0 | 1.0 | 1.0 |
| Curing conditions | | 100°C: 1 hour | 100°C: 1 hour | 100°C: 1 hour | 100°C: 1 hour | 100°C: 30 minutes | 80°C: 1 hour |
| Evaluation results | Absorption rate (%) | 35 | 35 | 35 | 35 | 35 | 35 |
| | Thermal fluidity | Good | Good | Good | Good | Good | Good |
| | Transparency | Good | Good | Good | Good | Good | Good |
| | Film-forming capability | Good | Good | Good | Good | Good | Good |
| | Adhesion to glass | Good | Good | Good | Good | Good | Good |
| | Gelation time (room temperature) | 1 week or more | 1 week or more | 1 week or more | 1 week or more | 1 week or more | 1 week or more |

TABLE 2 (continued)

| | | Example 13 | Example 14 | Example 15 | Example 17 | Example 18 |
|---|---|---|---|---|---|---|
| Composition | | R | S | T | U | V |
| Compound (A) | Type | TMDE-3 | TMDE-3B | TMDE-3C | DEGV-3 | DEGV-3 |
| | Amount (parts by mass) | 50 | 50 | 50 | 30 | 30 |
| Compound (B) | Type | PMHS | PMHS | PMHS | PMHS | PMHS |
| | Amount (parts by mass) | 50 | 50 | 50 | 70 | 70 |
| Catalyst (C) | Type | Carbonyldivinylmethyl-platinum complex | Cyclovinylmethylsiloxane-platinum complex | Cyclovinylmethylsiloxane-platinum complex | Cyclovinylmethylsiloxane-platinum complex | Cyclovinylmethylsiloxane-platinum complex |
| | Amount (parts by mass) | 0.1 | 0.1 | 0.1 | 0.1 | 0.1 |
| Additive | Type | - | VC | VC | VC | |
| | Amount (parts by mass) | - | 0.5 | 0.5 | 0.5 | |
| Content ratio ($W_A/W_B$) | | 1.0 | 1.0 | 1.0 | 0.43 | 0.43 |
| Curing conditions | | 80°C: 30 minutes | 80°C: 1 hour | 80°C: 1 hour | 80°C: 3 hours | 80°C: 3 hours |
| Evaluation results | Absorption rate (%) | 35 | 40 | 30 | 35 | 35 |
| | Thermal fluidity | Good | Good | Good | Good | Good |
| | Transparency | Good | Good | Good | Good | Good |
| | Film-forming capability | Good | Good | Good | Good | Good |
| | Adhesion to glass | Good | Good | Good | Good | Good |
| | Gelation time (room temperature) | 15 minutes | 1 week or more | 1 week or more | 1 week or more | 30 minutes |

Abbreviations of the components in Tables 1 and 2 are as follows.

TMDE-3: tri(2,2-bis(allyloxymethyl)-1-butoxy)aluminum (synthesized in section "4.1.1.")

TMDE-3B: a mixture including tri(2,2-bis(allyloxymethyl)-1-butoxy)aluminum (synthesized in section "4.1.1.")

TMDE-3C: a mixture including tri(2,2-bis(allyloxymethyl)-1-butoxy)aluminum (synthesized in section "4.1.1.")

DEGV-3: tri(2-(2-(vinyloxyethoxy)ethoxy)aluminum (synthesized in section "4.1.2.")

TD-3: tridodecylaluminum

(i-PrO)3Al: aluminum isopropoxide

PMHS: polymethylhydrogensiloxane

PEHS: polyethylhydrogensiloxane

PPMHS: polyphenyl(dimethylhydrogensiloxy)siloxane

PMS: polydimethylsiloxane

BT: benzothiazole

TDBPP: tris(2,4-di-t-butylphenyl)phosphite

ECHO: 1-ethynyl-1-cyclohexanol

DEM: diethyl maleate

NMP: N-methylpyrrolidone

VC: N-vinyl-epsilon-caprolactam

4.6.2. Evaluation methods

The hygroscopicity, the transparency, the film-forming capability, the adhesion to glass, and the storage stability (gelation time) of the films obtained in the section "4.6.1. Production of film" were evaluated by the following methods. Note that the thermal fluidity was evaluated using a film that was separately produced by the following method. The results are shown in Tables 1 and 2.

(1) Hygroscopicity

A film (thickness: 0.6 mm) was formed in a glass petri dish (inner diameter: 3 cm). The glass petri dish containing the film was put in a desiccator (internal volume: 800 $cm^3$) equipped with a hygrometer and a thermometer, and a change in humidity and temperature inside the desiccator was measured. The absolute humidity (Ha, %) was calculated by the following formula (7) using the measured relative humidity (Hr, %) and the measured centigrade temperature (Tc, °C). The difference between the initial absolute humidity (Ha(0 h)) and the absolute humidity 2 hours after starting the measurement (Ha(2 h)) was determined, and the absorption rate was calculated by the following formula (8), and evaluated.

$$Ha = 4.0 \times 10^{-3} \{\exp(6.4 \times 10^{-2} \cdot Tc)\} Hr \quad (7)$$

$$\text{Absorption rate (\%)} = 100 \times (Ha(0\ h) - Ha(2\ h)) / Ha(0\ h) \quad (8)$$

The absorption rate (%) is preferably 20% or more, more preferably 30% or more, and particularly preferably 40% or more.

(2) Thermal fluidity (heat resistance)

An adequate amount of each composition (A to V) was put in a sample tube, and heated at 80°C for 60 minutes to prepare a film (thickness: 2 mm) at the bottom of the sample tube. After allowing the film to sufficiently absorb moisture in air, the sample tube was capped and sealed. The sample tube was fixed so that the bottom (the side where the film was formed) was turned face up, and allowed to stand at 85°C. After 336 hours had elapsed, the state of the film was observed. The thermal fluidity was rated as "Good" when no change was observed in the film, and rated as "Bad" when deformation (sag) of the film was observed.

(3) Transparency

The transparency of the film obtained in the section "4.6.1. Production of film" was rated as "Good" when no turbidity was observed with the naked eye, and rated as "Bad" when turbidity was observed. A film that exhibits excellent transparency is preferable when the film is applied to a top-emission organic EL device or the like for which transparency is required.

(4) Film-forming capability

The film-forming capability was rated as "Good" when no cracks and irregularities were observed in the film obtained in the section "4.6.1. Production of film" with the naked eye, and rated as "Bad" when cracks or irregularities were observed in the film with the naked eye. A film in which cracks and irregularities are suppressed is preferable in applications such as an organic EL device.

(5) Adhesion to glass

The adhesion to glass was rated as "Good" when the film obtained in the section "4.6.1. Production of film" was not removed from glass in air, and rated as "Bad" when the film was removed from glass in air. A film that exhibits excellent adhesion to glass is preferable in applications such as a display material (i.e., applications that require adhesion to a glass substrate).

(6) Storage stability

Immediately after the preparation of the composition, a small amount of the composition was put in a transparent glass container, and the glass container was sealed and stored. The time elapsed until the composition had lost thermal fluidity after putting the composition in the glass container was evaluated as the gelation time. The thermal fluidity was checked by observing the state of the composition with the naked eye while tilting the glass container.

4.6.3. Evaluation results

As is clear from the results shown in Tables 1 and 2, it was found that the films formed using the compositions of Examples 1 to 18 exhibited excellent hygroscopicity and heat resistance due to the compound (A) and the compound (B). It was also found that the films formed using the compositions of Examples 1 to 18 exhibited excellent transparency, film-forming capability, and adhesion to glass.

While composition of Example 13 that did not contain the stabilizer gelled within about 15 minutes, the compositions of Examples 7 to 12 that contained the stabilizer did not gel for 1 week or more. It was thus found that the storage stability was dramatically improved by adding the stabilizer.

The composition of Example 2 contained TD-3 as the moisture absorbent in addition to TMDE-3. The properties

of the film were not affected by adding TD-3.

The content ratio ($W_A/W_B$) of the composition of Example 3 was 0.18. The absorption rate (30 %) decreased as compared with Examples 1 and 2 due to the above content ratio. However, the decrease in absorption rate was within the acceptable range.

In Example 5, PPMHS having an Si-H bond at the end was used as the compound (B). This did not affect the properties of the film.

In Example 6, a carbonyldivinylmethyl-platinum complex was used as the catalyst (C). This did not affect the properties of the film.

In Examples 14 and 15, a mixture containing TMDE-3 was used as the compound (A). Almost the same results as those of Example 12 were obtained in Examples 14 and 15 (i.e., the properties of the film were not affected by TMDE- 3).

In Examples 16 and 17, DEGV-3 was used as the compound (A) instead of TMDE-3. As a result, the curing time increased as compared with the case of using TMDE-3. However, the properties of the film were not affected by DEGV-3.

In Comparative Example 1, calcium oxide (CaO) that is generally used as a moisture absorbent was used instead of the compound (A). The calcium oxide was dispersed in the compound (B) without being dissolved. In Comparative Example 1, the absorption rate could not be measured since the solution was not cured (i.e., a film could not be formed).

In Comparative Example 2, barium oxide (BaO) that is generally used as a moisture absorbent was used instead of the compound (A). The barium oxide was dispersed in the compound (B) without being dissolved. In Comparative Example 2, the absorption rate could not be measured since the solution was not cured (i.e., a film could not be formed).

In Comparative Example 3, PMS that did not contain an Si-H bond was used instead of the compound (B). Since PMS did not react with the compound (A) so that the molecular weight of the components did not increase, the fluidity could not be reduced. Therefore, the absorption rate could not be measured since a film could not be formed. The transparency, the film-forming capability, and the adhesion to glass also could not be evaluated.

In Comparative Example 4, TD-3 (i.e., moisture absorbent) was used instead of the compound (A). In Comparative Example 4, a hydrosilylation reaction with the compound (B) did not occur since the organic group contained in TD-3 did not contain an unsaturated bond. Since the molecular weight of the components in the cured product did not increase, the fluidity could not be reduced, and deformation of the film was observed. Deformation of the film due to formation of a low-molecular-weight alkane or alcohol was also observed in the thermal fluidity test. The absorption rate, the transparency, the film-forming capability, and the adhesion to glass could not be evaluated.

In Comparative Example 5, $(i\text{-}PrO)_3Al$ (i.e., moisture absorbent) was used instead of the compound (A). In Comparative Example 5, a hydrosilylation reaction with the compound (B) did not occur since the organic group contained in $(i\text{-}PrO)_3Al$ did not contain an unsaturated bond. Since the molecular weight of the components included in the cured product did not increase, the fluidity could not be reduced, and deformation of the film was observed. Deformation of the film due to formation of a low-molecular-weight alcohol was observed in the thermal fluidity test. The absorption rate, the transparency, the film-forming capability, and the adhesion to glass could not be evaluated.

It was thus confirmed that the film formed using the composition containing the compound (A) and the compound (B) exhibited an excellent absorption rate, excellent heat resistance, excellent transparency, an excellent film-forming capability, and excellent adhesion to glass.

The invention is not limited to the above embodiments. Various modifications and variations may be made. For example, the invention includes various other configurations substantially the same as the configurations described in connection with the embodiments (e.g., a configuration having the same function, method, and results, or a configuration having the same objective and results). The invention also includes a configuration in which an unsubstantial section (part) described in the embodiments is replaced by another section (part). The invention also includes a configuration having the same effects as those of the configurations described in connection with the above embodiments, or a configuration capable of achieving the same objective as that of the configurations described in connection with the above embodiments. The invention further includes a configuration in which a known technique is added to the configurations described in connection with the above embodiments.

## LIST OF REFERENCE SYMBOLS

10: organic EL layer, 20: structure, 22: substrate, 24: sealing cap, 26: adhesive, 30: absorber layer, 100: organic EL device

**Claims**

1. A composition comprising (A) a compound shown by a general formula (1), and (B) a compound shown by a general formula (2),

$$(R^1)nM \qquad (1)$$

wherein $R^1$ independently represent a group selected from a substituted or unsubstituted alkyl group, a substituted or unsubstituted alkenyl group, a substituted or unsubstituted alkynyl group, a substituted or unsubstituted cycloalkyl group, a substituted or unsubstituted aryl group, a substituted or unsubstituted carboxyl group, and a group shown by $R^3O$-, provided that at least one of $R^1$ is a group that includes one or more unsaturated bonds, $R^3$ represents a group selected from a substituted or unsubstituted alkyl group, a substituted or unsubstituted alkenyl group, a substituted or unsubstituted alkynyl group, a substituted or unsubstituted cycloalkyl group, and a substituted or unsubstituted aryl group, n is an integer from 2 to 4 that is equal to a valence of M, and M represents an atom having a valence of 2 to 4,

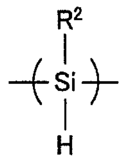 ···(2)

wherein $R^2$ represents an atom or a group selected from a hydrogen atom, a halogen atom, and an organic group.

2. The composition according to claim 1, wherein the compound (A) includes a carbon-carbon unsaturated bond.

3. The composition according to claim 1 or 2, wherein M in the general formula (1) represents at least one element selected from aluminum, boron, magnesium, calcium titanium, zirconium, and zinc.

4. The composition according to any one of claims 1 to 3, wherein the compound (B) is a polysiloxane that includes a repeating unit shown by a general formula (3).

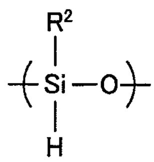 ···(3)

wherein $R^2$ represents an atom or a group selected from a hydrogen atom, a halogen atom, and an organic group.

5. The composition according to any one of claims 1 to 4, wherein the compound (A) is a compound shown by a general formula (4),

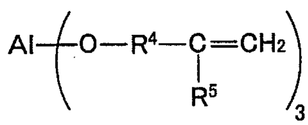 ···(4)

wherein $R^4$ independently represent a divalent organic group, and $R^5$ independently represent a hydrogen atom or a monovalent organic group.

6. The composition according to any one of claims 1 to 5, further comprising (C) a catalyst that promotes a hydrosilylation

reaction between the compound (A) and the compound (B).

**7.** The composition according to any one of claims 1 to 6, further comprising at least one stabilizer selected from benzothiazole, tris(2,4-di-t-butylphenyl)phosphite, 1-ethynyl-1-cyclohexanol, diethyl maleate, N-methylpyrrolidone, 1,3-dimethyl-2-imidazolidone, and N-vinyl-epsilon-caprolactam.

**8.** The composition according to any one of claims 1 to 7, the composition being used to absorb moisture.

**9.** A cured product formed using the composition according to claim 8.

**10.** An electronic device comprising the cured product according to claim 9.

FIG.1

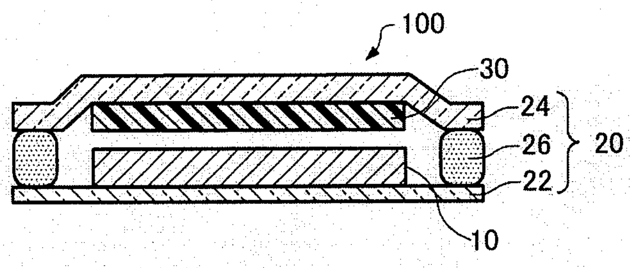


FIG.2

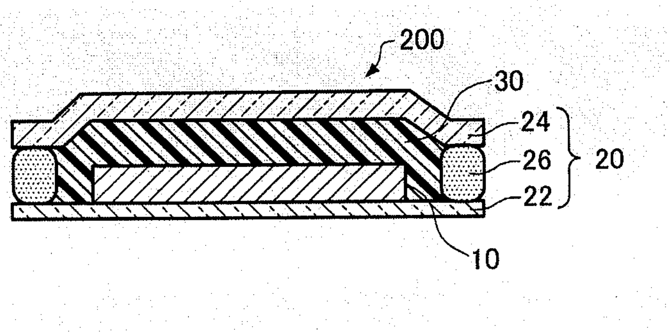

FIG. 3

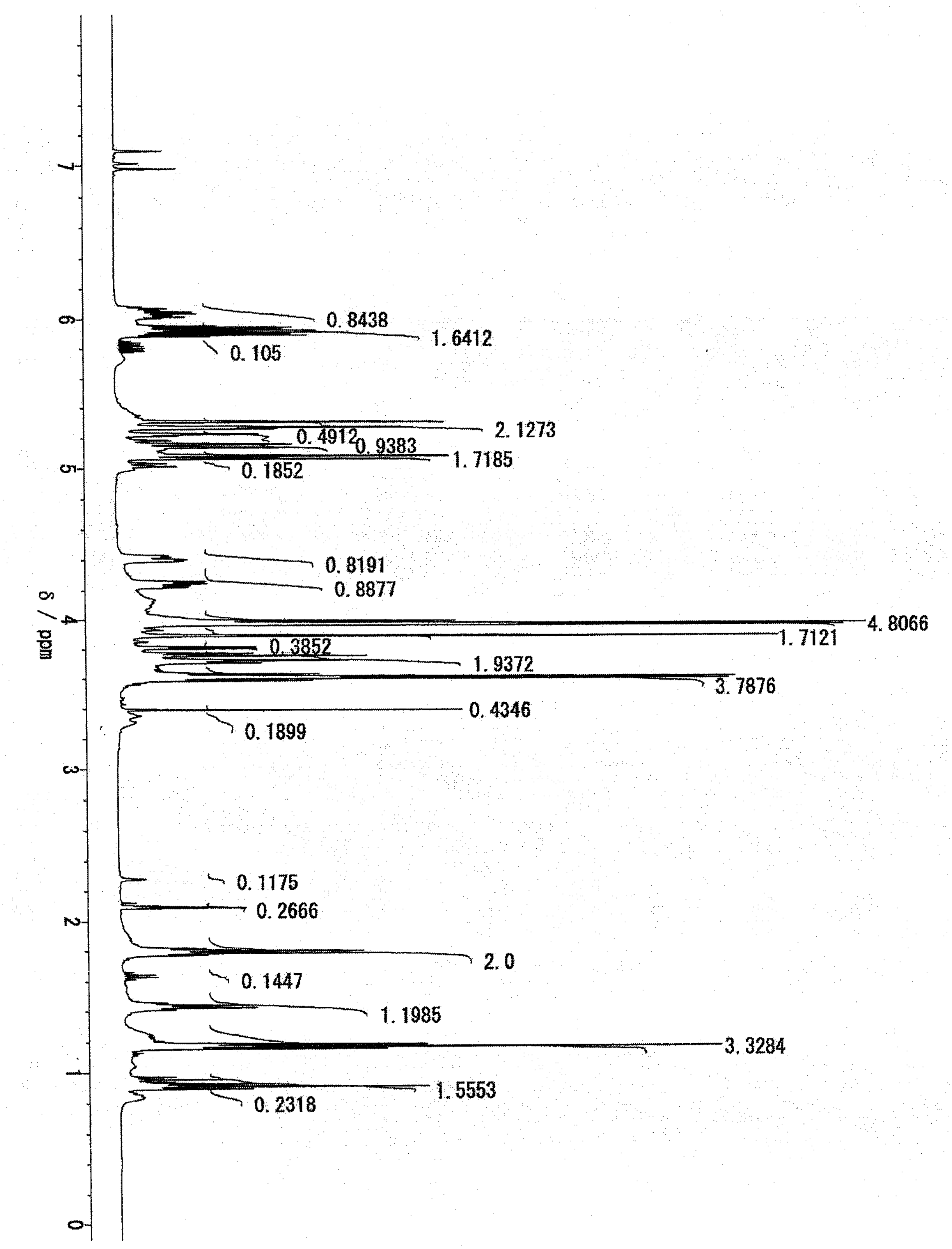

0. 8438
1. 6412
0. 105
2. 1273
0. 4912
0. 9383
1. 7185
0. 1852
0. 8191
0. 8877
4. 8066
1. 7121
0. 3852
1. 9372
3. 7876
0. 4346
0. 1899
0. 1175
0. 2666
2. 0
0. 1447
1. 1985
3. 3284
1. 5553
0. 2318
δ / ppm
7
6
5
4
3
2
1
0

FIG. 4

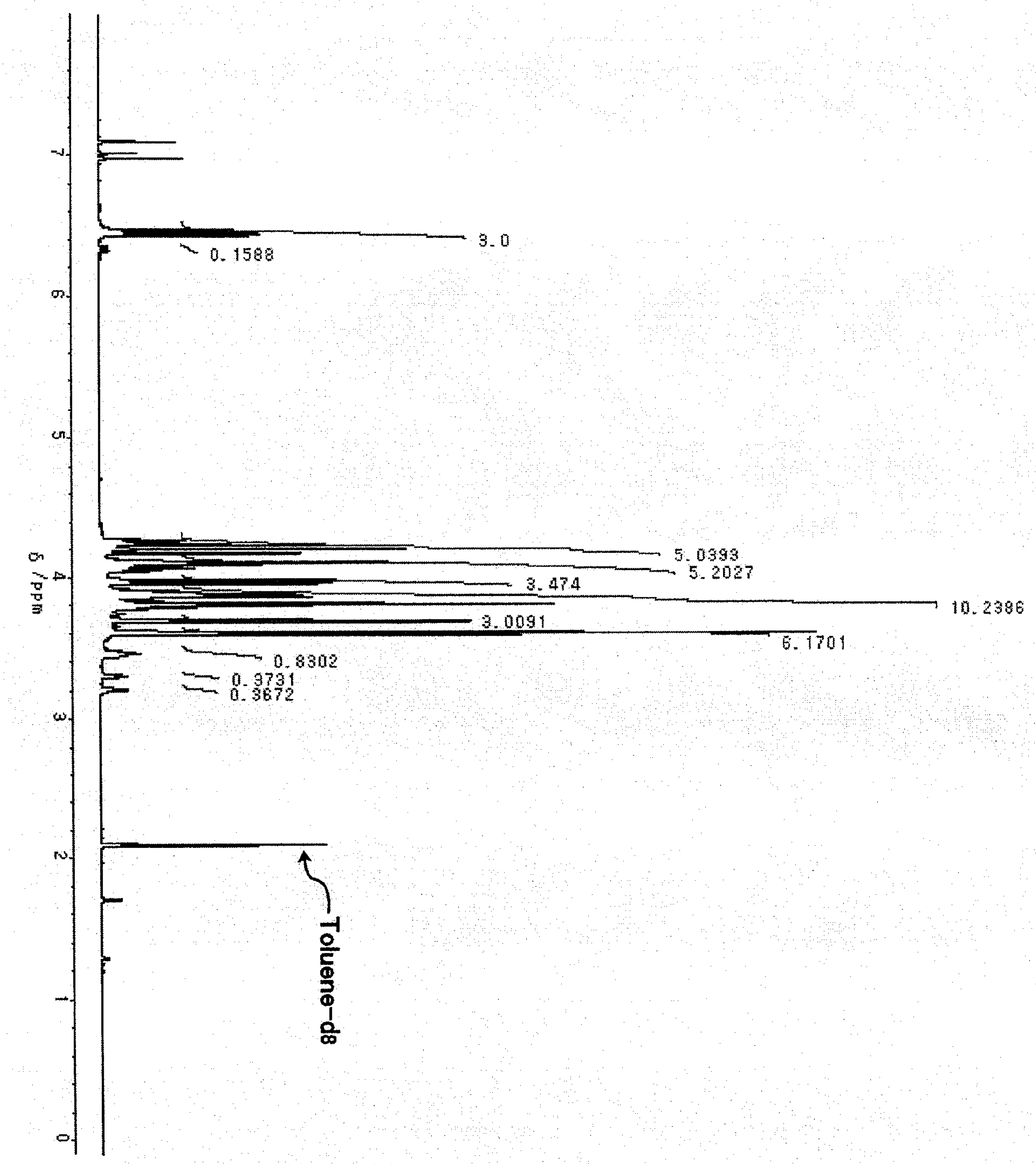
3.0
0.1588
5.0393
5.2027
3.474
10.2386
3.0091
6.1701
0.8302
0.9731
0.3672
Toluene-d8
δ / ppm
7
6
5
4
3
2
1
0

**INTERNATIONAL SEARCH REPORT**

International application No.
PCT/JP2010/068114

A. CLASSIFICATION OF SUBJECT MATTER
*C08L83/05*(2006.01)i, *C08G77/58*(2006.01)i, *C08K5/057*(2006.01)i, *H01L51/50* (2006.01)i, *H05B33/04*(2006.01)i

According to International Patent Classification (IPC) or to both national classification and IPC

B. FIELDS SEARCHED

Minimum documentation searched (classification system followed by classification symbols)
C08L83/00-83/16, C08G77/00-77/62, C08K3/00-13/08, H01L51/50, H05B33/04

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)
CA/REGISTRY(STN)

C. DOCUMENTS CONSIDERED TO BE RELEVANT

| Category* | Citation of document, with indication, where appropriate, of the relevant passages | Relevant to claim No. |
|---|---|---|
| X<br>Y | US 4780337 A (Massachusetts Institute of Technology),<br>25 October 1988 (25.10.1988),<br>claims<br>(Family: none) | 1-7,9-10<br>8 |
| X<br>Y | JP 2002-371185 A (Dow Corning Corp.),<br>26 December 2002 (26.12.2002),<br>claims (particularly, claims 4 to 7); paragraph [0055]<br>& US 2003/0013802 A1 & EP 1264865 A1 | 1-4,6-7,9-10<br>8 |
| X<br>Y | WO 2000/20425 A1 (RHODIA CHIMIE),<br>13 April 2000 (13.04.2000),<br>claims (particularly, claims 13 to 16, 19)<br>& FR 2784679 A | 1-4,6-7,9-10<br>8 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 11 January, 2011 (11.01.11) | 25 January, 2011 (25.01.11) |
| Name and mailing address of the ISA/<br>Japanese Patent Office<br>Facsimile No. | Authorized officer<br>Telephone No. |

Form PCT/ISA/210 (second sheet) (July 2009)

**INTERNATIONAL SEARCH REPORT**

International application No.
PCT/JP2010/068114

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2006-241273 A (3M Innovative Properties Co.), 14 September 2006 (14.09.2006), claims; paragraph [0001]; chemical formula 3 & US 2008/0303418 A1 & EP 1867212 A & WO 2006/093702 A2 | 8 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2005298598 A
- JP 2008518399 T
- JP 2003109921 A
- JP 2006080406 A